# EUROPEAN PATENT APPLICATION

(11) **EP 2 634 920 A2**
(43) Date of publication of application: **04.09.2013**
(21) Application number: 12162710.3
(22) Date of filing: 30.03.2012
(51) Int. Cl.: H03K 17/082

(54) **Overvoltage protection circuit and electronic device**

(30) Priority: 02.03.2012 CN 201210052569
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Deng, XUue-Bing, Shenzhen City, Guangdong Province (CN); Wang, Tao, Shenzhen City, Guangdong Province (CN); Cheng, Hai-Long, Shenzhen City, Guangdong Province (CN); Ma, Xiao-Hui, Shenzhen City, Guangdong Province (CN); Li, Xin-Ping, Shenzhen City, Guangdong Province (CN)
(74) Representative: Gray, John James

(57) **Abstract**

An overvoltage protection circuit is arranged in an electronic device for providing a proper working voltage to the electronic device. The overvoltage protection circuit includes a first selecting circuit and a second selecting circuit connected in parallel to the first selecting circuit between a voltage input port and a voltage output port of the overvoltage protecting circuit. When an input voltage from the input port is less than a first value, the input voltage is output to the output port directly through the first selecting circuit, and when the input voltage is greater than the first value, the input voltage is output to the output port after the value of the input voltage is reduced through the second selecting circuit.

## Description

### BackGround

### Technical Field

The present disclosure relates to an overvoltage protection circuit and an electronic device using the overvoltage protection circuit.

### Description of Related Art

Electronic devices (for example, mobile phones, cameras, or notebooks) are often provided with suitable adapters for powering or charging the batteries of the electronic devices. However, when an electronic device is connected to an unsuitable adapter which may provide an overlarge voltage to the electronic device, the electronic device may be damaged. Therefore, it is desirable to provide an overvoltage protection circuit to protect the electronic device.

### BRIEF DESCRIPTION OF THE DRAWINGS

The components in the drawing are not necessarily drawn to scale, the emphasis instead being placed upon clearly illustrating the principles of the present disclosure.

FIG. 1 is a module diagram of an overvoltage protection circuit arranged in an electronic device in accordance with an exemplary embodiment.

FIG. 2 is a circuit diagram of the overvoltage protection circuit in FIG. 1 in accordance with an exemplary embodiment.

### DETAILED DESCRIPTION

The disclosure is illustrated by way of example and not by way of limitation. It should be noted that references to "an" or "one" embodiment in this disclosure are not necessarily to the same embodiment, and such references mean at least one.

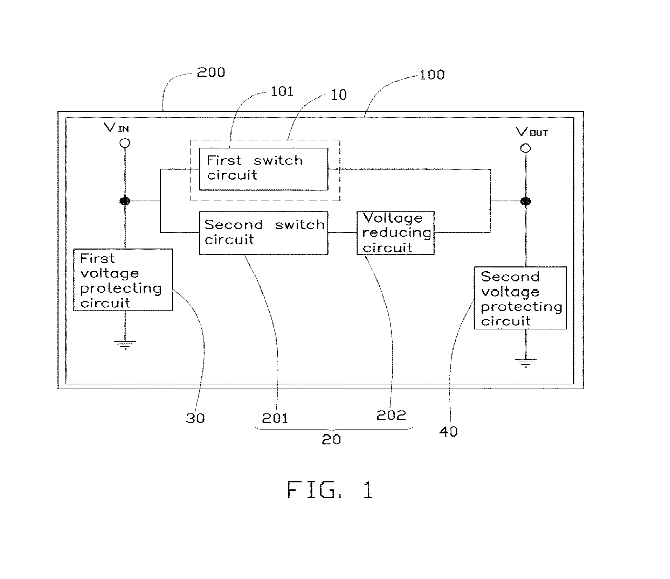

FIG. 1 is an overvoltage protection circuit 100 arranged in an electronic device 200 for providing a proper voltage to the electronic device 200. The electronic device 200 may be a mobile phone, a camera, or a DVD player, for example.

The overvoltage protection circuit 100 includes a voltage input port Vᵢₙ, a voltage output port Vₒᵤₜ, a first selecting circuit 10, and a second selecting circuit 20. The voltage input port Vᵢₙ receives an input voltage from an external device connected to the electronic device. The voltage output port Vₒᵤₜ outputs a working voltage to internal components of the electronic device 200. The first selecting circuit 10 and the second selecting circuit 20 are connected in parallel between the voltage input port Vᵢₙ and the voltage output port Vₒᵤₜ. The first selecting circuit 10 includes a first switch circuit 101. The second selecting circuit 20 includes a second switch circuit 201 and a voltage reducing circuit 202 connected in series to the second switch circuit 201, with the second switch circuit 201 being connected to the voltage input port Vᵢₙ and the voltage reducing circuit 202 being connected to the voltage output port Vₒᵤₜ. The voltage reducing circuit 202 reduces the value of the voltage input to the voltage reducing circuit 202.

When the input voltage from the voltage input port Vᵢₙ is less than a first value V₁, the first switch circuit 101 is turned on and the second switch circuit 201 is turned off. The voltage from the voltage input port Vᵢₙ is directly transmitted to the voltage output port Vₒᵤₜ, namely the voltage from the voltage input port Vᵢₙ is provided to the internal components of the electronic device 200. When the input voltage from the voltage input port V ᵢₙ is greater than the first value V₁, the first switch circuit 101 is turned off and the second switch circuit 201 is turned on. The voltage from the voltage input port Vᵢₙ is transmitted to the voltage reducing circuit 202 to reduce the value of the voltage first, and then the reduced voltage is transmitted to the voltage output port Vₒᵤₜ. In this embodiment, when the value of the input voltage from the voltage input port Vᵢₙ is greater than a second value V₂ which is greater than the first value V₁, the first switch circuit 101 and the second switch circuit 201 are both turned off, and the overvoltage protection circuit 100 does not provide any voltage to the electronic device 200.

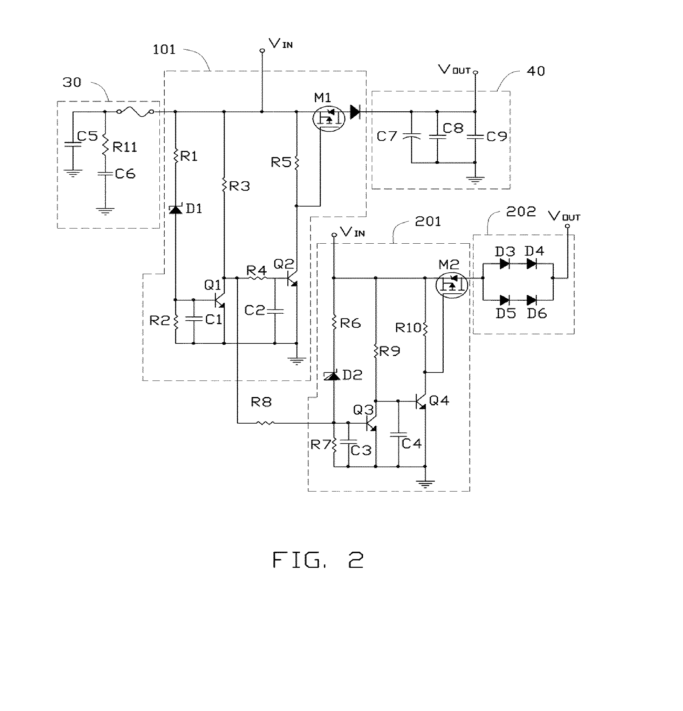

Referring to FIG. 2, the first switch circuit 101 includes a first diode D1, a first bipolar junction transistor (BJT) Q1, a second BJT Q2, and a first metal-oxide semiconductor (MOS) transistor M1. A cathode of the first diode D1 is connected to the voltage input port Vᵢₙ through a first resistor R1, and an anode of the first diode D1 is connected to a base of the first BJT Q1. The base of the first BJT Q1 is also connected to ground through a second resistor R2 and a first capacitor C1 connected in parallel to the second resistor R2, a collector of the BJT Q1 is connected to the voltage input port Vᵢₙ through a third resistor R3 and further connected to a base of the second BJT Q2 through a fourth resistor R4, and an emitter of the BJT Q1 is grounded. The base of the second BJT Q2 is further connected to ground through a second capacitor C2, a collector of the BJT Q2 is connected to the voltage input port Vᵢₙ through a fifth resistor R5 and further connected to a grid of the first MOS transistor M1, and an emitter of the BJT Q2 is grounded. A source of the first MOS transistor M1 is connected to the voltage input port Vᵢₙ, and a drain of the first MOS transistor M1 is connected to the voltage output port Vₒᵤₜ.

The second switch circuit 201 includes a second diode D2, a third BJT Q3, a fourth BJT Q4, and a second MOS transistor M2. A cathode of the second diode D2 is connected to the voltage input port Vᵢₙ through a sixth resistor R6, and an anode of the second diode D2 is connected to a base of the third BJT Q3. The base of the third BJT Q3 is also connected to ground through a seventh resistor R7 and a third capacitor C3 connected in parallel to the seventh resistor R7, the base of the third BJT Q3 is further connected to the collector of the first BJT Q1 through an eighth resistor R8, a collector of the BJT Q3 is connected to the voltage input port Vᵢₙ through a ninth resistor R9, and an emitter of the BJT Q3 is grounded. A base of the fourth BJT Q4 is connected to the collector of the third BJT Q3 and further connected to ground through a fourth capacitor C4, a collector of the BJT Q4 is connected to the voltage input port Vᵢₙ through a tenth resistor R10, and an emitter of the fourth BJT Q4 is grounded. A grid of the second MOS transistor M2 is connected to the collector of the BJT Q4, a source of the MOS transistor M2 is connected to the voltage input port Vᵢₙ, and a drain of the MOS transistor M2 is connected to an input port of the voltage reducing circuit 202.

The voltage reducing circuit 202 includes a third diode D3, a fourth diode D4, a fifth diode D5, and a sixth diode D6. The diode D3 is connected in series to the diode D4. The diode D5 is connected in series to the diode D6. The anode of the diode D3 and the anode of the diode D5 are connected together to form the input port of the voltage reducing circuit 202. The cathode of the diode D4 and the cathode of the diode D6 are connected together to form the voltage output port Vₒᵤₜ of the overvoltage protection circuit 100.

In this embodiment, the first BJT Q1, the second BJT Q2, the third BJT Q3, and the fourth BJT Q4 are NPN BJT. The first MOS transistor M1 and the second MOS transistor M2 are PMOS transistors. The reverse turn-on voltage of the diode D2 is greater than that of the diode D1. In this embodiment, the reverse turn-on voltage of the diode D1 is substantially equal to the first value V₁, and the reverse turn-on voltage of the diode D2 is substantially equal to the second value V₂.

When the overvoltage protection circuit 100 is applied in a vehicle power supply system, the voltage range the power supply system provides to the voltage input port Vᵢₙ may be 10V-16V, the diode D1 may be determined with the reverse turn-on voltage of 13V, and the diode D2 may be determined with the reverse turn-on voltage of 15V.

When the voltage input into the voltage input port Vᵢₙ is less than 13.7V (the reverse turn-on voltage of the first diode D1 is 13V and the voltage drop of the BJT Q1 is 0.7V), the first BJT Q1 is turned off, and the second BJT Q2 and the second BJT Q3 are turned on. The grid of the first MOS transistor M1 is connected to ground through the second BJT Q2, thus, the MOS transistor M1 is turned on, and the first switch circuit 101 is turned on. The base of the fourth BJT Q4 is connected to ground through the third BJT Q3, thus, the BJT Q4 is turned off, and the grid of the second MOS transistor M2 is connected to the voltage input port Vᵢₙ to get a high level. The second MOS transistor M2 is turned off, thus, the second switch circuit 201 is turned off. The overvoltage protection circuit 100 provides the voltage from the vehicle power supply system to the internal component of the electronic device 200 through the first switch circuit 101.

When the voltage input into the voltage input port Vᵢₙ is greater than 13.7V and less than 15.7V (the reverse turn-on voltage of the second diode D2 is 15V and the voltage drop of the BJT Q3 is 0.7V), the first BJT Q1 is turned on, and the second BJT Q2 and the third BJT Q3 are both turned off. The grid of the first MOS transistor M1 is connected to the voltage input port V ᵢₙ through the fifth resistor R5 to get a high level. Thus, the MOS transistor M1 is turned off, and the first switch circuit 101 is turned off. The grid of the second MOS transistor M2 is connected to ground through the fourth BJT Q4, thus, the second MOS transistor M2 is turned on, and the second switch circuit 201 is turned on. The overvoltage protection circuit 100 provides the voltage from the vehicle power supply system to the voltage reducing circuit 202 to decrease the voltage by the fourth diodes D3, D4, D5, and D6, and then provides the decreased voltage to the internal component of the electronic device 200.

When the voltage input into the voltage input port Vᵢₙ is greater than 15.7V, the first BJT Q1 and the third BJT Q3 are turned on, and the second BJT Q2, the fourth Q4, the first MOS transistor M1 and the second MOS transistor M2 are all turned off. The first switch circuit 101 and the second switch circuit 201 are thus turned off. The overvoltage protection circuit 100 does not provide any voltage to the internal components of the electronic device 200.

The overvoltage protection circuit 100 further includes a first voltage protecting circuit 30 and a second voltage protecting circuit 40. The first voltage protecting circuit 30 is connected between the voltage input port V ᵢₙ and ground, to prevent Electro Magnetic Interference (EMI) of the voltage of the voltage input port Vᵢₙ. The second voltage protecting circuit 40 is connected between the voltage output port Vₒᵤₜ and ground, to prevent EMI of the voltage from the voltage output port Vₒᵤₜ. In this embodiment, the first voltage protecting circuit 30 includes a fifth capacitor C5, a sixth capacitor C6, and an eleventh resistor R11. The fifth capacitor C5 is connected between the voltage input port Vᵢₙ and ground. The sixth capacitor C6 and the eleventh resistor R11 are connected in series between the voltage input port Vᵢₙ and ground. The second voltage protecting circuit 40 includes a seventh capacitor C7, an eighth capacitor C8, and a ninth capacitor C9. The capacitors C7, C8, and C9 are connected in parallel between the voltage output port Vₒᵤₜ and ground. In another embodiment, the first voltage protecting circuit 30 and the second voltage protecting circuit 30 can both be omitted.

In this embodiment, the values of the resistors R1, R2, R4, R5, R6, R7, R8, and R10 are 10K, the values of the resistors R3 and R9 are 100K, the values of the capacitors C1, C3, and C5 are 0.1µF, the values of the capacitors C2, C4, and C8 are 1µF, and the values of the capacitors C6 and C9 are 1000 pF.

Although the present disclosure has been specifically described on the basis of the exemplary embodiment thereof, the disclosure is not to be construed as being limited thereto. Various changes or modifications may be made to the embodiment without departing from the scope and spirit of the disclosure.

## Claims

1. An overvoltage protection circuit being arranged in an electronic device, for providing a proper working voltage to the electronic device, the overvoltage protection circuit comprising:
a voltage input port to receive an input voltage from an external device connected to the electronic device;
a voltage output port to output a working voltage to the electronic device;
a first selecting circuit, comprising:
a first switch circuit connected between the voltage input port and the voltage output port; and
a second selecting circuit connected in parallel to the first selecting circuit, comprising:
a second switch circuit connected to the voltage input port; and
a voltage reducing circuit connected in serial to the second switch circuit, the voltage reducing circuit being connected to the voltage output port;
wherein when an input voltage from the voltage input port is less than a first value, the first switch circuit is turned on and the second switch circuit is turned off, the input voltage is output to the voltage output port directly, and when the input voltage from the voltage input port is greater than the first value, the first switch circuit is turned off and the second switch circuit is turned on, and the input voltage is output to the voltage reducing circuit, the voltage reducing circuit reduces a value of the input voltage, and outputs the reduced voltage to the voltage output port.

2. The overvoltage protection circuit as described in claim 1, wherein when the input voltage from the voltage input port is greater than a second value which is greater than the first value, the first switch circuit and the second switch circuit are both turned off, and the overvoltage protection circuit does not provide any voltage to the electronic device.

3. The overvoltage protection circuit as described in claim 2, wherein the first switch circuit comprises a first diode, a first BJT, a second BJT, and a first MOS transistor, a cathode of the first diode is connected to the voltage input port through a first resistor, an anode of the first diode is connected to a base of the first BJT, the base of the first BJT is connected to ground through a second resistor and a first capacitor connected in parallel to the second resistor, a collector of the first BJT is connected to the voltage input port through a third resistor and further connected to a base of the second BJT through a fourth resistor, an emitter of the BJT is grounded, the base of the second BJT is connected to ground through a second capacitor, a collector of the second BJT is connected to the voltage input port through a fifth resistor and further connected to a grid of the first MOS transistor, an emitter of the second BJT is grounded, a source of the first MOS transistor is connected to the voltage input port, and a drain of the first MOS transistor is connected to the voltage output port.

4. The overvoltage protection circuit as described in claim 3, wherein the second switch circuit includes a second diode, a third BJT, a fourth BJT, and a second MOS transistor, a cathode of the second diode is connected to the voltage input port through a sixth resistor, an anode of the second diode is connected to a base of the third BJT, the base of the third BJT is connected to ground through a seventh resistor and a third capacitor connected in parallel to the seventh resistor, the base of the third BJT is further connected to the collector of the first BJT through an eighth resistor, a collector of the third BJT is connected to the voltage input port through a ninth resistor, an emitter of the third BJT is grounded, a base of the fourth BJT is connected to the collector of the third BJT and connected to ground through a fourth capacitor, a collector of the fourth BJT is connected to the voltage input port through a tenth resistor, an emitter of the fourth BJT is grounded, a grid of the second MOS transistor is connected to the collector of the fourth BJT, a source of the second MOS transistor is connected to the voltage input port, and a drain of the second MOS transistor is connected to an input port of the voltage reducing circuit.

5. The overvoltage protection circuit as described in claim 4, wherein the voltage reducing circuit comprises a third diode, a fourth diode, a fifth diode, and a sixth diode, the third diode is connected in series to the fourth diode, the fifth diode is connected in series to the sixth diode, the anode of the third diode and the anode of the fifth diode are connected together to form the input port of the voltage reducing circuit, and the cathode of the fourth diode and the cathode of the sixth diode are connected together to form the voltage output port of the overvoltage protecting circuit.

6. The overvoltage protection circuit as described in claim 5, wherein a reverse turn-on voltage of the second diode is bigger than a reverse turn-on voltage of the first diode.

7. The overvoltage protection circuit as described in claim 6, wherein the first BJT, the second BJT, the third BJT, and the fourth BJT are NPN BJT, and the first MOS transistor and the second MOS transistor are PMOS transistors.

8. The overvoltage protection circuit as described in claim 3, further comprising a first voltage protecting circuit, wherein the first voltage protecting circuit comprises a fifth capacitor, a sixth capacitor, and an eleventh resistor, the fifth capacitor is connected between the voltage input port and ground, and the sixth capacitor and the eleventh resistor are connected in series between the voltage input port and ground.

9. The overvoltage protection circuit as described in claim 8, further comprising a second voltage protecting circuit, wherein the second voltage protecting circuit comprises a seventh capacitor, an eighth capacitor, and a ninth capacitor, and the seventh capacitor, the eighth capacitor, and the ninth capacitor are connected in parallel between the voltage output port and ground.

10. An electronic device arranging an overvoltage protection circuit for providing a proper working voltage to the electronic device, the overvoltage protection circuit comprising:
a voltage input port to receive an input voltage from external of the electronic device;
a voltage output port to output a working voltage to the electronic device;
a first selecting circuit, comprising:
a first switch circuit connected between the voltage input port and the voltage output port; and
a second selecting circuit connected in parallel to the first selecting circuit, comprising:
a second switch circuit connected to the voltage input port; and
a voltage reducing circuit connected in serial to the second switch, the voltage reducing circuit being connected to the voltage output port;
wherein when an input voltage from the voltage input port is less than a first value, the first switch circuit is turned on and the second switch circuit is turned off, the overvoltage protection circuit provides the input voltage to the voltage output port directly, and when the input voltage from the voltage input port is bigger than the first value, the first switch circuit is turned off and the second switch circuit is turned on, and the overvoltage protection circuit provides the input voltage from the voltage input port to the voltage reducing circuit to reduce a value of the input voltage, and then outputs the reduced voltage to the voltage output port.
